**Europäisches Patentamt**

**European Patent Office**

**Office européen des brevets**

(19)

(11) Veröffentlichungsnummer : **0 091 062**
**B1**

(12)

# EUROPÄISCHE PATENTSCHRIFT

(45) Veröffentlichungstag der Patentschrift :
26.03.86

(51) Int. Cl.⁴ : **H 04 B   9/00**, H 03 K   5/02

(21) Anmeldenummer : **83103072.1**

(22) Anmeldetag : **28.03.83**

(54) **Schaltungsanordnung zur Verstärkung von elektrischen Signalen.**

(30) Priorität : **01.04.82 DE 3212188**

(43) Veröffentlichungstag der Anmeldung :
**12.10.83 Patentblatt 83/41**

(45) Bekanntmachung des Hinweises auf die Patenterteilung : **26.03.86 Patentblatt 86/13**

(84) Benannte Vertragsstaaten :
**AT CH DE FR GB IT LI NL SE**

(56) Entgegenhaltungen :
**DE-A- 2 712 292**
**DE-A- 3 010 535**
**DE-B- 1 933 157**
**DE-C- 2 828 662**
**US-A- 3 968 399**
**ELECTRONIC DESIGN, Band 27, Nr. 21, 11. Oktober**
**1979, D. MENNIE "Fiber-optics detector and amp on**
**one chip fight RFI and EMI", Seiten 29-30**

(73) Patentinhaber : **Siemens Aktiengesellschaft**
**Berlin und München Wittelsbacherplatz 2**
**D-8000 München 2 (DE)**

(72) Erfinder : **Rehm, Hans, Dipl.-Ing.**
**Wildenfelser Strasse 19**
**D-8000 München 60 (DE)**
Erfinder : **Breitenfeld, Horst, Ing.**
**Frühlingstrasse 68**
**D-8035 Gauting (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung bezieht sich auf eine Schaltungsanordnung zur Verstärkung von elektrischen Signalen, mit wenigstens einer Verstärkerstufe, deren Eingang galvanisch an eine Vorspannungsquelle und kapazitiv an eine Signalspannungsquelle angeschlossen ist.

Eine derartige Schaltungsanordnung ist bereits aus Electronic Design Nr. 21, 11. Oktober 1979, Seiten 29 bis 30 bekannt. Die bekannte Schaltungsanordnung besteht aus mehreren in Kette geschalteten Differenzverstärkern und hat einen ECL-Ausgang. Drei Differenzverstärker sind galvanisch miteinander gekoppelt. Der erste dieser drei Differenzverstärker ist mit seinen beiden Eingängen über je einen Koppelkondensator an eine symmetrische Signalspannungsquelle angeschlossen. Der eine Eingang dieses Differenzverstärkers ist über einen Widerstand an eine Vorspannungsquelle, der andere Eingang über ein Siebglied an einen der beiden Ausgänge des zweiten Differenzverstärkers angeschlossen, so daß sich eine Gleichstromrückkopplung ergibt. Die bekannte Schaltungsanordnung geht davon aus, daß zur Erzeugung eines ECL-Pegels ein einfacher Verstärker verwendet werden kann, wenn bekannt ist, daß das empfangene Signal ein Tastverhältnis von ungefähr 50 % hat. Hat das Signal ein davon abweichendes Tastverhältnis, so ergibt sich eine Änderung der vom Ausgang des zweiten zum einen Eingang des ersten Differenzverstärkers geführten Gleichspannung.

Aus der DE-PS-28 28 662 ist bereits eine Schaltungsanordnung zum wahlweisen Durchschalten oder Sperren von Signalen hoher Bandbreite bekannt, bei der die elektronischen Schalter als logische Verknüpfungsglieder in ECL-Technik ausgebildet sind. Mit Hilfe dieser Verknüpfungsglieder werden frequenzmodulierte Signale hoher Bandbreite, insbesondere durch Videosignale modulierte Träger übertragen.

ECL-Signale können durch längere Koaxialkabel von z. B. bis etwa 100 m Länge so gedämpft werden, daß am Ende eines Kabels ein Leitungsempfänger erforderlich ist, der die gedämpften Signale auf ECL-Pegel verstärkt. Soll dabei das Signaltastverhältnis bzw. der $a_{k2}$-Wert möglichst verbessert, keinesfalls aber verschlechtert werden, so erfordert dies eine relativ aufwendige Schaltung bzw. einen unerwünschten Arbeitspunktabgleich.

In der Regel werden zur digitalen ECL-Signalübertragung über größere Entfernungen symmetrische Kabel mit symmetrischen Leitungempfängern verwendet. Dies ist jedoch insbesondere bei einer Rechteck-FM-Übertragung nicht ohne weiteres praktikabel. Außerdem werden solche Leitungsempfänger galvanisch im Gegentaktbetrieb angesteuert und bringen keine Verbesserung des Signaltastverhältnisses.

Aufgabe der Erfindung ist es daher, eine Schaltungsanordnung der eingangs genannten Art derart auszubilden, daß elektrische Signale mit möglichst geringem Aufwand auf einen für ECL-Verknüpfungsglieder geeigneten Pegel verstärkt werden können. Insbesondere soll die Schaltungsanordnung zur Verstärkung von frequenzmodulierten ECL-Signalen geeignet sein und dabei erforderlichenfalls eine Verbesserung des Signaltastverhältnisses bewirken.

Gemäß der Erfindung wird die Schaltungsanordnung zur Lösung dieser Aufgabe derart ausgebildet, daß die Verstärkerstufen jeweils durch ein ECL-Verknüpfungsglied gebildet sind und daß als Vorspannungsquelle ein weiteres ECL-Verknüpfungsglied dient, und daß bei dem weiteren Verknüpfungsglied ein Ausgang mit einem Eingang verbunden ist, und daß die die Verstärkerstufe(n) und die Vorspannungsquelle bildenden Verknüpfungsglieder durch gleichartige Verknüpfungsglieder ein und desselben ECL-Bausteines gebildet sind.

Durch diese Maßnahme ergibt sich in vorteilhafter Weise eine Schaltungsanordnung, die sich aus üblichen ECL-Verknüpfungsgliedern zusammensetzen läßt und daher mit einem besonders geringen Aufwand realisierbar ist. Ein weiterer Vorteil besteht darin, daß bei einer derartigen Schaltungsanordnung durch die Ansteuerung des Verknüpfungsgliedes über eine C-Kopplung eine Verbesserung des Signaltastverhältnisses bzw. eine Erhöhung der Klirrdämpfung $a_{k2}$ erreicht wird. Die Arbeitspunktspannung läßt sich mit Hilfe eines Verknüpfungsgliedes so ableiten, daß Temperatur- und Versorgungsspannungsänderungen sowie Exemplarstreuungen vernachlässigbar sind und ein Arbeitspunktsabgleich entfällt.

Ein besonders günstiger Arbeitspunkt ergibt sich in Weiterbildung der Erfindung dadurch, daß die von der Vorspannungsquelle abgegebene Vorspannung wenigstens annähernd gleich dem mittleren Spannungswert im linearen Verstärkungsbereich der Übertragungskennlinie des als Verstärkerstufe dienenden ECL-Verknüpfungsgliedes ist.

Insbesondere ist das als Vorspannungsquelle dienende Verknüpfungsglied durch ein NOR-Glied gebildet, dessen Ausgang mit einem seiner Eingänge verbunden ist.

In weiterer Ausgestaltung der Erfindung ist das als Vorspannungsquelle dienende Verknüpfungsglied durch ein NOR-Glied gebildet, dessen Ausgang mit einem seiner Eingänge verbunden ist. Auf diese Weise lassen sich übliche integrierte Schaltungen für die Schaltungsanordnung besonders gut ausnutzen.

Bei einer vorteilhaften Ausführungsform der Schaltung sind von vier Verknüpfungsgliedern eines ECL-Bausteines drei als Verstärkerstufen in Kette geschaltet. Bei einer anderen vorteilhaften Ausgestaltung sind von vier Verknüpfungsgliedern eines ECL-Bausteines eines eine Vorverstärkerstufe und zwei weitere an die Vorverstärkerstufe angeschlossene Endverstärkerstufen. Auf diese Weise lassen sich mit besonders einfachen Mitteln zwei- bis dreistufige Leitungsempfänger realisieren.

Zweckmäßigerweise enthält wenigstens das die Vorspannungsquelle bildende Verknüpfungsglied eine Anordnung zur Erzeugung einer Referenzspannung. Die Schaltungsanordnung läßt sich vorteilhaft in Einrichtungen zur Ubertragung von frequenzmodulierten ECL-Breitbandsignalen mittels Koaxialleitungen verwenden. Aufgrund der genannten vorteilhaften Eigenschaften ist die Schaltungsanordnung insbesondere als unsymmetrischer HF-Leitungsempfänger in Baugruppen von optischen Breitbandnetzen geeignet, insbesondere in Verbindung mit einer Übertragung von FM-Signalen in einem Grundkanal bis 60 MHz, insbesondere 10 bis 60 MHz, eines optischen Breitbandnetz-Übertragungssystems, bei dem Koaxialkabel unterschiedlicher Länge, insbesondere bis maximal 100 m vorgesehen sind, so daß mehr oder weniger stark gedämpfte Empfangssignale auftreten können, die jeweils klirrarm bezüglich $a_{k2}$ auf ECL-Pegel zu verstärken sind.

Besonders vorteilhaft ist eine Verwendung der Schaltungsanordnung zur Reduzierung der ersten Oberwelle in Einrichtungen, bei denen über ECL-Verknüpfungsglieder geführte frequenzmodulierte Signale im Frequenzmultiplex zu übertragen sind.

Die Erfindung wird anhand der in den Figuren dargestellten Ausführungsbeispiels näher erläutert.

Es zeigen

Figur 1 eine Schaltungsanordnung zur Verstärkung von elektrischen Signalen mittels ECL-Verknüpfungsgliedern im Prinzip,

Figur 2 eine dreistufige Schaltungsanordnung zur Verstärkung von Signalen mittels ECL-Verknüpfungsgliedern,

Figur 3 eine Schaltungsanordnung zur Verstärkung von elektrischen Signalen mit einer Vorverstärkerstufe und zwei Endverstärkerstufen,

Figur 4 eine Schaltung eines OR-NOR-Verknüpfungsgliedes eines ECL-Bausteines,

Figur 5 Übertragungskennlinien des in Fig. 4 gezeigten Verknüpfungsgliedes,

Figur 6 die Frequenzabhängigkeit der Spannungsverstärkung des Verknüpfungsgliedes nach Fig. 4,

Figur 7 ein FM-Signal mit dem Tastverhältnis $v_t = Tp/\tau$

Figur 8 Signalformen des Eingangssignals und eines Ausgangssignals bei einem Tastverhältnis $v_t = 2$ und

Figur 9 die Wirkungsweise der Verbesserung des Tastverhältnisses.

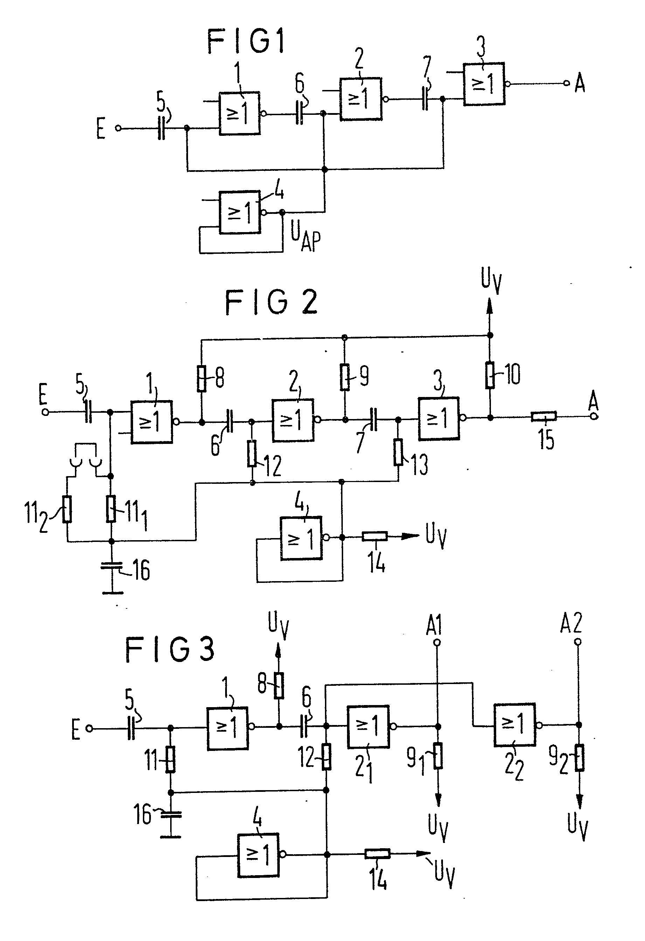

Fig. 1 zeigt eine Schaltungsanordnung zur Verstärkung von ECL-Signalen, die mit Hilfe der vier Verknüpfungsglieder des Bausteines MC 10 102 der Schaltkreisserie 10 K bzw. ECL 10 000 realisiert ist. die NOR-Glieder 1, 2, 3 sind über die Kondensatoren 6 und 7 in Reihe geschaltet. Dem Eingang des NOR-Gliedes 1 ist der Kondensator 5 vorgeschaltet. Das NOR-Glied 4 dient zur Erzeugung der Arbeitspunktspannung $U_{AP}$, die den Eingängen der NOR-Glieder 1, 2, 3 jeweils unmittelbar zugeführt ist. Die gewünschte Arbeitspunktspannung stellt sich dadurch am Ausgang des NOR-Gliedes 4 selbsttätig ein, daß der Ausgang mit einem der Eingänge unmittelbar verbunden ist.

Fig. 2 zeigt weitere Einzelheiten der Schaltungsanordnung nach Fig. 1. Zwischen dem NOR-Glied 4 und den Eingängen der NOR-Glieder 1 ... 3 ist jeweils ein Widerstand $11_1$, 12, 13 eingefügt, wobei der dem Eingang der Eingangsstufe vorgeschaltete Widerstand $11_1$ durch Parallelschaltung des Parallelwiderstandes $11_2$ eingestellt werden kann. Außerdem ist der Ausgang des NOR-Gliedes 4 über den Widerstand 14 an Versorgungsspannung und über den Kondensator 16 an Masse geführt.

Bei dem als Eingangsstufe dienenden NOR-Glied 1 ist der Eingang über den Kondensator 5 an den Eingang der Schaltungsanordnung geführt. Die Ausgänge der NOR-Glieder 1 ... 3 sind über je einen Widerstand 8, 9, 10 an die Versorgungsspannung $U_v$ des betreffenden Ausgangs-Emitterfolgers geführt. Die Stromversorgung für den Baustein selbt ist in der Figur nicht dargestellt. Zwischen dem Ausgang des NOR-Gliedes 3 und dem Ausgang der Schaltungsanordnung liegt der Widerstand 15.

Die Widerstände 8, 9 und 10 sind die Arbeitswiderstände der Ausgangs-Emitterfolger.

Der Widerstand 15 dient zur Anpassung an eine nachfolgende Leitung mit definiertem Wellenwiderstand.

Bei der Schaltungsanordnung nach Fig. 3 sind von den vier Verknüpfungsgliedern des ECL-Bausteines ein erstes als Vorverstärkerstufe, ein zweites und drittes jeweils als Ausgangsverstärkerstufe und ein viertes als Vorspannungsquelle verwendet. Da die Eingänge der Ausgangsverstärkerstufen $2_1$ und $2_2$ unmittelbar miteinander verbunden sind, ist für die Zuführung der Vorspannung zu diesen Verstärkerstufen ein einziger Widerstand 12 vorgesehen.

Abweichend von dem in Fig. 2 gezeigten Ausführungsbeispiel sind die Ausgänge der NOR-Glieder $2_1$ und $2_2$ jeweils unmittelbar mit dem zugehörigen Ausgang $A_1$ bzw. $A_2$ der Schaltungsanordnung verbunden.

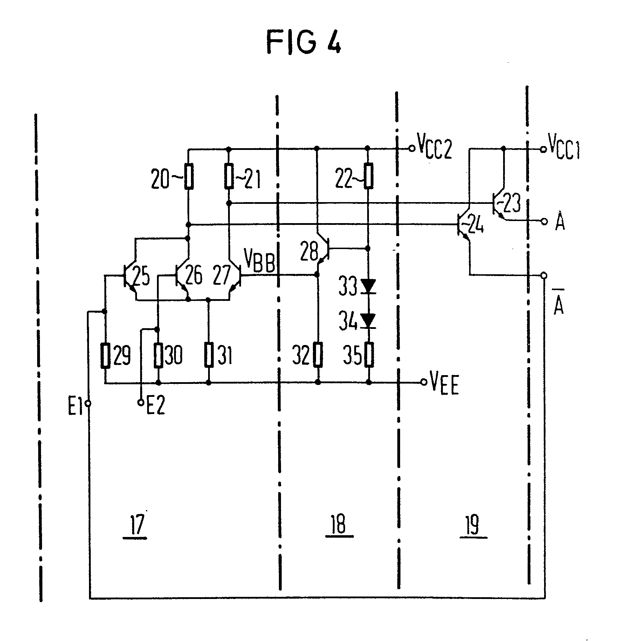

Nähere Einzelheiten des als Verstärkerstufe bzw. Vorspannungsquelle verwendeten OR-NOR-Gliedes gehen aus Fig. 4 hervor. Das NOR-Glied enthält einen Differenzverstärker mit den Transistoren 25 und 26 auf der einen und dem Transistor 27 auf der anderen Seite. Die Transistoren 25, 26, 27 haben den gemeinsamen Emitterwiderstand 31. Während die Basisanschlüsse der Transistoren 25 und 26 jeweils mit einem Eingang des NOR-Gliedes verbunden sind, ist die Basis des Transistors 27 an den Ausgang der internen Vorspannungsquelle 18 angeschlossen. Die Vorspannungsquelle 18 besteht aus dem Transistor 28, dessen Basis an den aus dem Widerstand 22, den Dioden 33 und 34 und dem Widerstand 35 bestehenden Spannungsteiler angeschlossen ist und in dessen Emitterzweig der Widerstand 32 liegt. Diese Referenzspannungsquelle 18 gibt am Emitter des Transistors T4 eine Referenzspannung $V_{BB} = -1,175\ V$ ab.

Die Kollektoren der Transistoren 26 und 27 sind an die Basisanschlüsse der emitterseitig mit den Ausgängen A und $\overline{A}$ verbundenen Ausgangstransistoren 23 und 24 geführt.

Bei der Verwendung als Verstärkerstufe dient der Differenzverstärker für das zu verstärkende Signal als begrenzender Verstärker. Bei der Nutzbarmachung der internen Referenzspannungsquelle ist, wie in Fig. 4 gezeigt, der NOR-Ausgang $\overline{A}$ unmittelbar mit einem der beiden Eingänge $E_1$, $E_2$ verbunden. Durch diese Gegenkopplung stellt sich am NOR-Ausgang $\overline{A}$ die interne Referenzspannung $V_{BB}$ selbsttätig ein.

Bei optischen Breitbandnetzen kann es zweckmäßig sein, Frequenzmodulation (FM) zu verwenden ; das FM-Signal darf dabei, sofern es nicht mit anderen Signalen zu einem Frequenzmuktiplexsignal zusammengefaßt ist, amplitudenbegrenzt werden, so daß sich eine sog. Rechteck-FM ergibt. Durch Anwendung der ECL-Technologie können viele Funktionen in den verschiedensten Baugruppen u. a. auch im Koppelfeld mit üblichen ECL-Schaltkreisen realisiert werden. Die Übertragung dieser ECL-Signale erfolgt im Grundkanal 30 MHz $\pm$ 17 MHz aus räumlichen Gründen über Strecken bis zu 100 m Länge.

Bei der Übertragung von FM-Signalen werden längere Leitungen aus Reflexionsgründen beidseitig angepaßt betrieben. Ferner werden Koaxial-Kabel verwendet, da eine symmetrische Übertragung der HF-Signale, z. B. über Twisted-Pair-Kabel aus Übersprechgründen nicht ohne weiteres möglich ist. Bei Einrichtungen der genannten Art ist es zweckmäßig, sie durch einen Leitungsempfänger auf ECL-Pegel zu verstärken, insbesondere für den Fall, daß sich auf den Baugruppen weitere ECL-Schaltungen befinden. Die sendeseitige Anpassung ergibt bei Verwendung üblicher ECL-Treiber eine Dämpfung von ca. 5 dB ; hinzu kommt noch die Dämpfung des Koaxial-Kabels, die bei einer Frquenz f = 30 MHz und dem Kabel RG 316/U mit 100 m Länge ca. 16 dB beträgt. Somit muß die Spannungsverstärkung z. B. in diesem Falle $v_U \geqslant 21\ dB$ betragen.

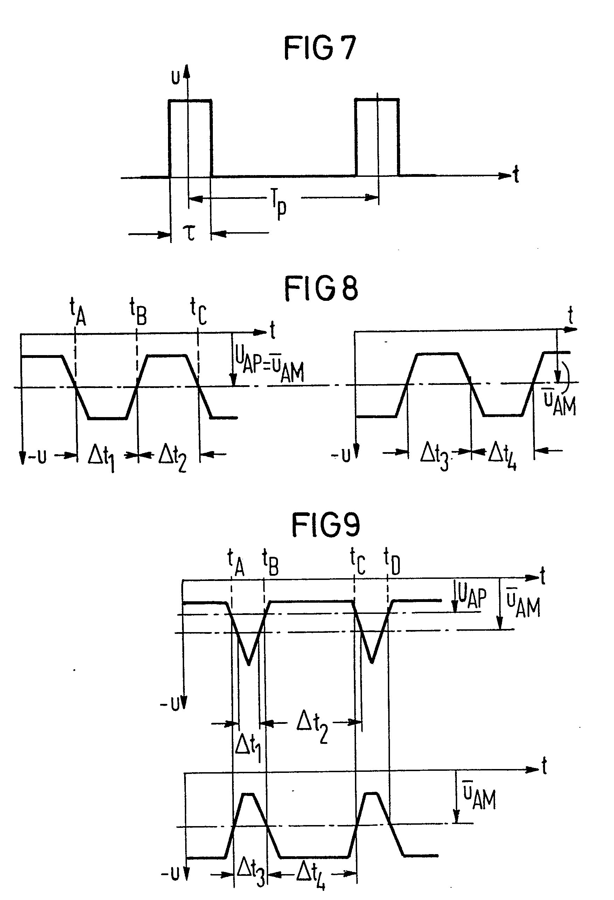

Bei Rechtecksignalen steht nach DIN 45402 das Tastverhältnis $V_t = To/\tau$ (Fig. 7) in direktem Zusammenhang mit den Klirrprodukten 2. Ordnung bzw. mit der Ausbildung der 1. Oberwelle.

Je mehr das Tastverhältnis von 2 abweicht, desto größer bildet sind die 1. Oberwelle aus, die bei einer folgenden Übertragung im Frequenzmuktiplexsignal den nächsten Kanal stören kann, sofern ihr Pegelabstand zur Grundwelle nicht größer als etwa 20 dB ist.

Da das FM-Signal auf dem Übertragungsweg eine größere Anzahl von ECL-Gattern bzw. -Verknüpfungsgliedern durchläuft, insbesondere in Koppel- und/oder Verteilnetzen, kann das Tastverhältnis, bedingt durch die Toleranzen der Gatter-Schaltsohwellen, ungünstig werden.

Der Leitungsempfänger soll aus diesen Gründen eine Tastverhältnisverbesserung bewirken, um den geforderten Abstand der 1. Oberwelle von insbesondere mehr als 20 dB zu erreichen.

Ein Aufbau auf normalen Verstärkerstufen mit diskreten Bauelementen erfordert in der Regel einen Abgleich, und die Verwendung eines Comparators mit ECL-Ausgang, z. B. vom Typ AM 685 wäre relativ aufwendig.

Überlegungen im Rahmen der Erfindung haben ergeben, daß die genannten Anforderungen mit einem IC der ECL-10K- Serie, insbesondere MC 10102 erfüllbar sind und zwar dadurch, daß die drei ersten Gatter eines Bausteines C-gekoppelt in Serie geschaltet werden und an jedem Gattereingang eine Arbeitspunktspannung angelegt wird, die aus dem vierten Gatter desselben Bausteins abgeleitet ist. Eine Schaltungsanordnung für einen derartigen Leitungsempfänger geht aus Fig. 1 hervor.

Der Baustein MC 10102 besteht ausvier NOR-Gattern mit je zwei Eingängen in ECL-Technik. Eines der Gatter besitzt zusätzlich einen OR-Ausgang ; die Schaltung geht aus Fig. 4 hervor.

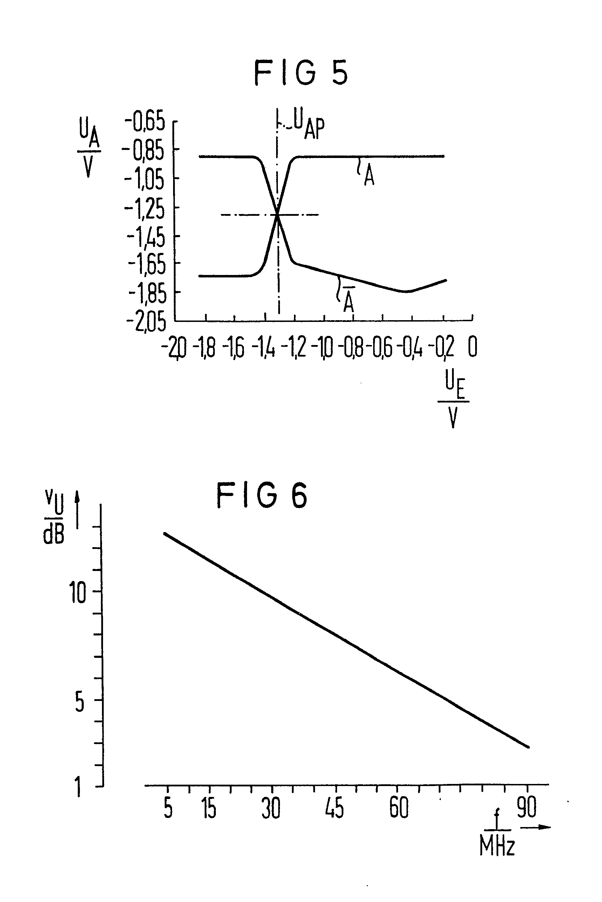

Die Übertragungskennlinie eines MECL-10K-Gatters ist aus Fig. 5 und die im « linearen Bereich » gemessene, frequenzabhängige Spannungsverstärkung aus Fig. 6 ersichtlich.

Zur Erfüllung der systembedingten Anforderungen ist eine möglichst genaue Einstellung des Arbeitspunktes erforderlich. Die günstigste Arbeitspuktspannung $U_{AP}$ ist der mittlere Spannungswert im linearen Verstärkungsbereich der Übertragungskennlinie nach Fig. 5. Nur bei dieser Einstellung der Vorspannung $U_{AP}$ wird die mögliche Spannungsverstärkung ausgenutzt und nur dann wird das Tastverhältnis $v_t = 2$ eines Eingangssignales nicht verschlechtert.

Die Arbeitspunktspannung $U_{AP}$ wird mit Hilfe des Gatters 4 entsprechend Fig. 4 dadurch erzeugt, daß der invertierende Ausgang $\overline{A}$ mit dem Eingang E1 verbunden wird. Mit dieser Gegenkopplung kann in vorteilhafter Weise eine temperaturstabilisierte baustein-interne Referenzspannung, die ansonsten extern nicht zugänglich ist, genutzt werden. Sonst übliche frequenzabhängige Gegenkopplungsmaßnahmen zur Arbeitspunktstabilisierung bei Verstärkern und Komperatoren sind aufwendiger, insbesondere bei Benötigung mehrerer Gatterstufen, da dabei für jede Gatterstufe eine entsprechende Gegenkopplungsstufe erforderlich wäre.

Da bei jedem Leitungsempfänger eines der vier Gatter des jeweils verwendeten IC zur Erzeugung der Vorspannung dient, werden die Streungen der Verstärkungskennlinie, die durch Bauteile-, Temperatur- und Versorgungsspannungstoleranzen verursacht werden, besonders gut kompensiert.

Da Gleichspannungsanteile des Eingangssignals durch die C-Kopplungen abgeblockt sind, verstärken die einzelnen Stufen des Leitungsempfängers um die eingestellte Arbeitspunkt-

spannung $U_{AP}$, d. h. Eingangssignale mit einem Tastverhältnis $v_t = 2$ schwingen nach jeder C-Kopplung am Verstärkereingang amplitudensymmetrisch um $U_{AP}$ ($U_{AP} = \overline{u}_{AM}$, siehe Fig. 8), so daß sich für das Ausgangssignal ebenfalls ein Tastverhältnis von $v_t = 2$ ergibt.

Fig. 8 zeit Signalformen bei einem Tastverhältnis $v_t = 2$. Links ist das Eingangssignal, rechts daneben das Ausgangssignal dargestellt. Dabei bedeuten :

$\overline{u}_{AM}$    Amplitudenmittenwert
$U_{AP}$    Arbeitspunktspannung
$v_{tE}$    Tastverhältnis am Gattereingang
$v_{tA}$    Tastverhältnis am Gatterausgang
$t_A \ldots t_D$    Gatter-Umschaltzeitpunkte

$$\Delta t_1 = \Delta t_3 \,;\, \Delta t_2 = \Delta t_4$$
$$\Rightarrow v_{tE} = v_{tA}$$

Weicht das Tastverhältnis des Eingangssignals von 2 ab ($v_t \neq 2$), so schwingt es nach der C-Kopplung nicht amplitudensymmetrisch um $U_{AP}$ ($U_{AP} \neq \overline{u}_{AM}$).

Dadurch und bedingt durch die endliche Flankensteilheit des Signals ergibt sich in jedem Fall eine Verbesserung des Tastverhältnisses und damit des $a_{k2}$-Wertes.

Fig. 9 zeigt Wirkungsweise der Tastverhältnisverbesserung.

In vorteilhafter Weise lautet das Ergebnis :

da $\Delta t_3 > \Delta t_1$ und $\Delta t_4 < \Delta t_2$
ist $v_{tA}$ besser als $v_{tE}$

**Patentansprüche**

1. Schaltungsanordnung zur Verstärkung von elektrischen Signalen, mit wenigstens einer Verstärkerstufe ($1, 2, 3 ; 1, 2_1, 2_2$), deren Eingang galvanisch an eine Vorspannungsquelle (4) und kapazitiv an eine Signalspannungsquelle angeschlossen ist, dadurch gekennzeichnet, daß die Verstärkerstufen jeweils durch ein ECL-Verknüpfungsglied gebildet sind und daß als Vorspannungsquelle (4) ein weiteres ECL-Verknüpfungsglied dient, und daß bei dem weiteren Verknüpfungsglied ein Ausgang (A) mit einem Eingang (E1) verbunden ist, und daß die die Verstärkerstufe(n) ($1, 2, 3 ; 1, 2_1, 2_2$) und die Vorspannungsquelle (4) bildenden Verknüpfungsglieder durch gleichartige Verknüpfungsglieder ein und desselben ECL-Bausteines gebildet sind.

2. Schaltungsanordnung nach Anspruch 1, dadurch gekennzeichnet, daß die von der Vorspannungsquelle (4) abgegebene Vorspannung ($U_{AP}$) wenigstens annähernd gleich dem mittleren Spannungswert im linearen Verstärkungsbereich der Übertragungskennlinie des als Verstärkerstufe ($1, 2, 3 ; 1, 2_1, 2_2$) dienenden ECL-Verknüpfungsgliedes ist.

3. Schaltungsanordnung nach Anspruch 1 oder 2, dadurch gekennzeichnet, daß das als Vorspannungsquelle (4) dienende Verknüpfungsglied durch ein NOR-Glied gebildet ist, dessen Ausgang (A) mit einem seiner Eingänge (E1) verbunden ist (Fig. 4).

4. Schaltungsanordnung nach einem der Ansprüche 1 bis 3, dadurch gekennzeichnet, daß von vier Verknüpfungsgliedern eines ECL-Bausteines drei als Verstärkerstufen ($1, 2, 3 ; 1, 2_1, 2_2$) in Kette geschaltet sind (Fig. 1, 2).

5. Schaltungsanordnung nach einem der Ansprüche 1 bis 4, dadurch gekennzeichnet, daß von vier Verknüpfungsgliedern eines ECL-Bausteines eines eine Vorverstärkerstufe (1) und zwei weitere an die Vorverstärkerstufe (1) angeschlossene Endverstärkerstufen ($2_1$, $2_2$) sind (Fig. 3).

6. Schaltungsanordnung nach einem der Ansprüche 1 bis 5, dadurch gekennzeichnet, daß wenigstens das die Vorspannungsquelle (4) bildende Verknüpfungsglied eine Anordnung (18) zur Erzeugung einer Referenzspannung enthält (Fig. 4).

7. Schaltungsanordnung nach einem der Ansprüche 1 bis 6, gekennzeichnet durch die Verwendung in Einrichtungen zur Übertragung von frequenzmodulierten ECL-Breitbandsignalen mittels Koaxialleitungen.

8. Schaltungsanordnung nach einem der vorhergehenden Ansprüche, gekennzeichnet durch die Verwendung der Schaltungsanordnung zur Reduzierung der ersten Oberwelle in Einrichtungen, bei denen über ECL-Verknüpfungsglieder geführte frequenzmodulierte Signale im Frequenzmultiplex zu übertragen sind.

**Claims**

1. A circuit arrangement for the amplification of electrical signals, with at least one amplifier stage ($1, 2, 3 ; 1, 2_1, 2_2$) whose input is electrically connected to a bias voltage source (4) and is capacitively connected to a signal voltage source, characterised in that the amplifier stages are each formed by an ECL logic-linking element, and that a further ECL logic-linking element serves as a bias voltage source (4), and that in the case of the further logic-linking element an output (A) is connected to an input (E1), and that the logic-linking elements which form the amplifier stage(s) ($1, 2, 3 ; 1, 2_1, 2_2$) and the bias voltage source (4) are formed by similar logic-linking elements of one and the same ECL module.

2. A circuit arrangement as claimed in Claim 1, characterised in that the bias voltage ($U_{AP}$) emitted from the bias voltage source (4) is at least approximately equal to the mean voltage value in the linear amplification range of the transmission curve of the ECL logic-linking element which serves as the amplifier stage ($1, 2, 3 ; 1, 2_1, 2_2$).

3. A circuit arrangement as claimed in Claim 1 or 2, characterised in that the logic-linking element which serves as the bias voltage source (4) is formed by a NOR-gate whose output (A) is connected to one of its inputs (E1) (Fig. 4).

4. A circuit arrangement as claimed in one of the Claims 1 to 3, characterised in that of four logic-linking elements of an ECL module, three are connected in a cascade arrangement as amplifier stages (1, 2, 3 ; 1, $2_1$, $2_2$) (Fig. 1, 2).

5. A circuit arrangement as claimed in one of the Claims 1 to 4, characterised in that of four logic-linking elements of an ECL-module, one represents a preliminary amplifier stage (1) and two others represent output amplifier stages ($2_1$, $2_2$) connected to the preliminary amplifier stage (1) (Fig. 3).

6. A circuit arrangement as claimed in one of the Claims 1 to 5, characterised in that at least that logic-linking element which forms the bias voltage source (4) contains an arrangement (18) which serves to generate a reference voltage (Fig. 4).

7. A circuit arrangement as claimed in one of the Claims 1 to 6, characterised by use in devices for the transmission of frequency-modulated ECL wide-band signals via coaxial lines.

8. A circuit arrangement as claimed in one of the preceding Claims, characterised by use of the circuit arrangement to reduce the first harmonic in devices in which frequency-modulated signals are conducted across ECL logic-linking elements to be transmitted in frequency multiplex operation.

## Revendications

1. Montage pour l'amplification de signaux électriques, comportant au moins un étage amplificateur (1, 2, 3 ; 1, $2_1$, $2_2$), dont l'entrée est raccordée galvaniquement à une source de tension de polarisation (4) et capacitivement à une source de tension de signaux, caractérisé par le fait que les étages amplificateurs sont formés respectivement par un circuit logique ECL et qu'on utilise comme source de tension de polarisation (4) un circuit logique ECL supplémentaire, que dans le circuit logique supplémentaire, une sortie A est reliée à une entrée (E1) et que les circuits logiques constituant le ou les étages amplificateurs (1, 2, 3 ; 1, $2_1$, $2_2$) et la source de tension de polarisation (4) sont formés par des circuits logiques de même type d'un même module ECL.

2. Montage suivant la revendication 1, caractérisé par le fait que la tension de polarisation ($U_{AP}$) délivrée par la source de tension de polarisation (4) est au moins approximativement identique à la valeur de tension moyenne dans la plage linéaire d'amplification de la courbe caractéristique de transfert du circuit logique ECL utilisé comme étage amplificateur (1, 2, 3 ; 1, $2_1$, $2_2$).

3. Montage suivant la revendication 1 ou 2, caractérisé par le fait que le circuit logique utilisé comme source de tension de polarisation (4) est formé par une porte NON-OU dont la sortie A est reliée à l'une de ses entrées (E1) (figure 4).

4. Montage suivant l'une des revendications 1 à 3, caractérisé par le fait que parmi quatre circuits logiques d'un module ECL, trois circuits logiques sont branchés en tant qu'étages amplificateurs (1, 2, 3 ; 1, $2_1$, $2_2$) selon un montage itératif (figures 1, 2).

5. Montage suivant l'une des revendications 1 à 4, caractérisé par le fait que parmi quatre circuits logiques d'un module ECL, l'un des circuits logiques est un étage préamplificateur (1) et deux autres circuits logiques sont des étages amplificateurs terminaux ($2_1$, $2_2$) raccordés à l'étage préamplificateur (1) (figure 3).

6. Montage suivant l'une des revendications 1 à 5, caractérisé par le fait qu'au moins le circuit logique constituant la source de tension de polarisation (4) contient un dispositif (18) servant à produire une tension de référence (figure 4).

7. Montage suivant l'une des revendications 1 à 6, caractérisé par son utilisation dans les dispositifs servant à transmettre des signaux à large bande ECL modulés en fréquence au moyen de câbles coaxiaux.

8. Montage suivant l'une des revendications précédentes, caractérisé par son utilisation pour réduire le premier harmonique dans les dispositifs, dans lesquels des signaux modulés en fréquence et délivrés par l'intermédiaire des circuits logiques ECL doivent être transmis selon un multiplexage de fréquences.

FIG 1

FIG 2

FIG 3

# FIG 4

# FIG 5

# FIG 6

# FIG 7

# FIG 8

# FIG 9

4